# EUROPÄISCHE PATENTSCHRIFT

(11) **EP 2 147 452 B1**
(45) Veröffentlichungstag und Bekanntmachung des Hinweises auf die Patenterteilung: **17.04.2013**
(21) Anmeldenummer: 08735395.9
(22) Anmeldetag: 28.04.2008
(51) Int. Cl.: H01J 37/32, H01L 21/677, H01L 21/00, C23C 14/56, C23C 16/54, H01L 21/67, C23C 16/458

(54) **BEHANDLUNGSSYSTEM FÜR FLACHE SUBSTRATE**
TREATMENT SYSTEM FOR FLAT SUBSTRATES
SYSTÈME DE TRAITEMENT DE SUBSTRATS PLATS

(30) Priorität: 09.05.2007 DE 102007022252; 10.05.2007 DE 102007022431
(43) Veröffentlichungstag der Anmeldung: 27.01.2010
(73) Patentinhaber: Leybold Optics GmbH, 63775 Alzenau (DE)
(72) Erfinder: GEISLER, Michael, 63607 Wächtersbach (DE); MERZ, Thomas, 63743 Aschaffenburg (DE); RÖDER, Mario, 63571 Gelnhausen (DE); BECKMANN, Rudolf, 63546 Hammersbach (DE)
(74) Vertreter: Pohlmann, Bernd Michael
(86) Internationale Anmeldenummer: PCT/EP2008/003414
(87) Internationale Veröffentlichungsnummer: WO 2009/003552

(56) Entgegenhaltungen:
- EP-A- 1 524 215
- EP-A- 1 746 182
- DE-A1- 2 653 736
- DE-A1- 4 330 266
- DE-A1- 10 103 341
- JP-A- 2 141 568
- JP-A- 10 121 237
- JP-A- 2000 177 842
- US-A1- 2002 078 892
- US-A1- 2004 102 025
- US-A1- 2004 149 389
- US-A1- 2006 096 857
- US-A1- 2006 218 680
- US-B1- 6 241 857
- US-B1- 6 818 560

## Beschreibung

Die Erfindung betrifft einen Reaktor und ein Verfahren zur Behandlung von flachen Substraten gemäß den unabhängigen Patentansprüchen.

Aus der EP 0312447 B1 ist bereits ein Verfahren zur Herstellung von dünnen Schichten auf Substraten für elektronische oder optoelektronische Verwendung des eines Plasma-Ablagerungsprozesses bekannt (PECVD), wobei in Gegenwart eines Ablagerungsplasmas Reaktionsgase zur Herstellung der Schichten in eine Plasmabox eingeführt werden, die in einer Vakuumkammer angeordnet ist. Dabei wird in der Vakuumkammer ein Druck erzeugt und aufrechterhalten, der niedriger ist als derjenige der in der Plasmabox herrscht. Ähnliche Verfahren sind auch aus der EP 02218112 B1 sowie der US 4,798,739 bekannt. Weitere Reaktoren, insbesondere mit mehreren Kammern zur Behandlung eines Substrats werden in der DE 19901426 A1, US 6,183,564 B1, US 5,944,857 sowie in der japanischen Patentzusammenfassung JP 06267808 A offenbart.

Das erwähnte zur kostengünstigen Herstellung von Solarzellen mit einem hohen Wirkungsgrad eingesetzte PECVD-Verfahren, bei dem als Prozessgase Silan und Wasserstoff verwendet werden, weißt als wichtige Depositionsparameter den Gasdruck, den Gasfluss, die Leistungsdichte und Frequenz der Plasmaanregung, die Substrattemperatur, die Gaszusammensetzung sowie den Abstand zwischen Elektrode und Gegenelektrode auf. Zur Erreichung von hohen Dispositionsraten sind dabei hohe Gasflüsse und eine Reduzierung des Elektrodenabstandes von Bedeutung. Günstige Abstände zwischen den Elektroden liegen dabei in Bereichen zwischen 0,5 und 15 mm. Bei derart geringen Abständen stellt die Einbringung der Substrate in den Raum zwischen den Elektroden ein Problem dar, wobei zu berücksichtigen Ist, dass zur Gewährleistung einer hohen Produktivität mit einem unterbrechungsfreien Schichtwachstum bei der Beschichtung eine Parallelprozessierung notwendig ist, zu deren Realisierung Cluster-Anlagen eingesetzt werden, die bei den heute gewünschten Substratgrößen von 1,4m2 und mehr einen hohen konstruktiven Aufwand erfordern.

Bereits bekannt sind Zentral-Cluster bei denen parallel prozessierende Kammern um einen Mittelpunkt herum angeordnet sind, in dem eine zentrale Handlingvorrichtung sitzt. Nachteilig bei Zentral-Cluster-Systemen ist, dass bei großen Substraten die zentrale Handlingvorrichtung sehr groß und schwer zugänglich wird und dass die Anzahl der Prozesskammem und damit der erreichbare Durchsatz begrenzt sind. Bekannt sind ferner Vertikal-Cluster-Anlagen, die beispielsweise in der Herstellung von TFT-Displays eingesetzt werden. Vertikal-Cluster-Systeme beinhalten eine turmartige Architektur mit flachen Prozesskammern, wodurch eine effektive Gastrennung zwischen den Komponenten schwierig und die Anzahl von aufeinander aufgebauten Schichten begrenzt wird.

Die DE 101 03 341 A1 beschreibt beispielsweise eine Plasmabehandlungsvorrichtung mit einer Vakuumkammer, in der eine obere Elektrode und eine untere Elektrode angeordnet sind. Weiter gehören dazu eine Hochfrequenzversorgungseinheit zum Anlegen einer Hochfrequenzspannung, eine Abstandjustiereinrichtung zum Justieren des Abstands zwischen den zwei Elektroden, und eine Werkstücktransporteinrichtung zur Be- und Entladung eines Raumbereichs zwischen den zwei Elektroden. Die Verwendung der Plasmabehandlungsvorrichtung erlaubt eine Verringerung eines Abstands zwischen den zwei Elektroden und eine Erhöhung einer Ätzrate. Ferner kann das Werkstück in einfacher Weise zu und von dem Raumbereich zwischen den zwei Elektroden durch Erweitern des Abstands zu- und abgeführt werden.

In der US 6,818,560 B1 werden eine Plasmabehandlungsvorrichtung sowie ein Verfahren zur Plasmabehandlung beschrieben, die es ermöglichen, das Auftreten einer unerwünschten Entladung bei der Werkstückbearbeitung zu verhindern, ohne das Design zu ändern bzw. ohne den vorgesehenen Durchsatz zu verringern.

US 2004/102025 A1 beschreibt ein Plasmabearbeitungsverfahren, bei dem das Plasma-Trennen, das Entfernen einer Maske und das Entfernen von Mikro-Rissen durch Ausführen von Plasmabearbeitung an einem Halbleiter-Wafer ausgeführt werden.

Die US 2006/096857 A1 betrifft eine physikalische Gasphasenabscheidungskammer (PVD) mit einer drehbaren Vorrichtung zur Aufnahme von Substraten, die dem gleichmäßigen Auftragen von dünnen Beschichtungen auf ein Zielobjekt dient. Die Orientierung des Zielobjektes kann, bezogen auf die Substrataufnahmevorrichtung, vertikal oder in einem bestimmten Winkel (etwa 0° bis 45°) relativ zur Drehachse der Substrataufnahmevorrichtung eingestellt werden.

Aufgabe der vorliegenden Erfindung ist es eine effiziente Plasma - Behandlung von flachen Substraten zu ermöglichen, insbesondere einen entsprechenden Reaktor sowie ein Verfahren zur Behandlung von flachen Substraten bereitzustellen, ferner ein einfaches und sicheres Handling flacher Substrate sowie eine verbesserte Herstellung von behandelten Substraten zu ermöglichen.

Die Aufgabe wird mit den Merkmalen der unabhängigen Patentansprüche gelöst.

Der erfindungsgemäße Reaktor zur Behandlung von flachen Substraten mit einer Vakuumkammer, in der ein Prozessraum angeordnet ist, wobei eine erste Elektrode und eine Gegenelektrode zur Erzeugung eines Plasmas zur Behandlung einer zu behandelnden Oberfläche verhanden sind und zwei gegenüberliegende Wände des Prozessraums bilden und Mitteln zum Einbringen und Mitteln zur Entfernung von gasförmigen Material, insbesondere Beschichtungs- oder Reinigungsmaterial in den und/oder aus dem Prozessraum, wobei das zumindest eine Substrat durch die Gegenelektrode auf ihrer der Elektrode zugewandten Vorderseite aufnehmbar ist und einer Be- und Entladungsöffnung der Vakuumkammer, vorzugsweise mit einer Verschlussvorrichtung, zeichnet sich dadurch aus, dass eine Vorrichtung zum Variieren des relativen Abstandes zwischen den Elektroden vorgesehen ist, wobei ein erster relativ großer Abstand bei einer Be- oder Entladung der Prozesskammer mit dem zumindest einen Substrat und eine zweiter relativ geringer Abstand bei Durchführung der Behandlung des zumindest einen Substrats verhanden ist. Als flache Substrate werden im Rahmen der Erfindung insbesondere Substrate für Solarzellen, Glasscheiben oder dergleichen bezeichnet. Typisch sind rechteckige Substrate von 1,4 m² und mehr. Als Behandlung wird im Rahmen der Erfindung jede Art von Modifizierung eines Substrats mittels eines zwischen zwei flachen Elektroden erzeugten Plasma bezeichnet, insbesondere jedoch ein PECVD - Verfahren.

Vorteilhaft können Elektrode und Gegenelektrode mittels der Vorrichtung zum Variieren des Abstandes vergleichsweise dicht aneinander herangeführt werden, wobei sich auch der Abstand

Der erfindungsgemäße Reaktor ist dadurch gekennzeichnet, dass eine Haltestruktur (33) in der Vakuumkammer (11) für die Elektrode (5) verhanden und die Elektrode (5) in einer Ausnehmung der Haltestruktur (33) angeordnet ist, dass die Gegenelektrode (7) während der Durchführung der Behandlung die Ausnehmung abdeckt, wobei zwischen einem Randbereich der Gegenelektrode (7) und einem Randbereich der Ausnehmung ein Spalt gebildet ist, der derart dimensioniert ist, dass ein im Prozessraum (9) erzeugtes Plasma innerhalb des Prozessraums (9) gehalten wird oder haltbar ist. zwischen der Elektrode und dem Substrat verringert. Vorteilhaft kann dadurch bei einer Beschichtung der Schichtaufbau positiv beeinflusst werden. Es ist denkbar, auch während der Behandlung des Substrats den Abstand und damit die Prozessparameter zu variieren, um den Behandlungsvorgang zu kontrollieren. Es versteht sich, dass bei einem Variieren des Abstandes sowohl die Elektrode als auch die Gegenelektrode oder auch beide bewegt werden können.

Der Reaktor ist dadurch ausgezeichnet, daß zumindest eine der Elektroden einen Gasverteiler für Beschichtungsmaterial und/oder Reinigungsmaterial aufweist.

Ferner kann vorteilhaft während der Durchführung der Behandlung das Substrat mit der zu behandelnden Oberfläche nach unten mit einem Winkel Alpha in einem Bereich zwischen 0 ° und 45 ° gegenüber der Lotrichtung angeordnet sein. Damit wird die Gefahr einer Partikelkontaminierung der empfindlichen zu behandelnden oder behandelten Oberfläche des Substrats reduziert, da weniger Partikel auf diese Oberfläche gelangen können. Derartige Partikel entstehen, wenn im Prozessraum gebildete Schichten, beispielsweise aus Silizium abplatzen. Bevorzugt sind Werte des Winkel Alphas von 1°, 3°, 5°, 7°, 9°, 11°, 13°, 15°, 17°, 20°, 25°, 30°, 40°, 45°, da hiermit der horizontale Platzbedarf durch den Reaktor reduziert wird.

Gemäß einem weiteren Aspekt der Erfindung wird ein Verfahren zur Behandlung von flachen Substraten in einem Reaktor zur Verfügung gestellt mit einer Vakuumkammer, in der ein Prozessraum angeordnet ist, wobei eine erste Elektrode und eine Gegenelektrode zur Erzeugung eines Plasmas zur Behandlung einer zu behandelnden Oberfläche vorgesehen sind und zwei gegenüberliegende Wände des Prozessraums bilden und Mitteln zum Einbringen und Mitteln zur Entfernung von gasförmigen Material, insbesondere Beschichtungs-oder Reinigungsmaterial in den oder aus dem Prozessraum, wobei der relative Abstand zwischen den Elektroden einstellbar ist und ein erster relativ großer Abstand bei einer Be- oder Entladung der Prozeßkammer mit dem zumindest einen Substrat und eine zweiter relativ geringer Abstand bei Durchführung der Beschichtung des zumindest einen Substrats vorgesehen ist, dadurch gekennzeichnet, dass eine Haltestruktur (33) in der Vakuumkammer (11) für die Elektrode (5) vorgesehen und die Elektrode (5) in einer Ausnehmung der Haltestruktur (33) angeordnet wird, dass die Gegenelektrode (7) während der Durchführung der Behandlung die Ausnehmung abdeckt, wobei zwischen einem Randbereich der Gegenelektrode (7) und einem Randbereich der Ausnehmung ein Spalt gebildet wird, der derart dimensioniert ist dass ein im Prozessraum (9) erzeugtes Plasma innerhalb des Prozessraums (9) gehalten wird oder haltbar ist.

Weitere vorteilhalte Ausführungsformen der Erfindung in ihren verschiedenen Aspekten sind den abhängigen Ansprüchen zu entnehmen.

Nachfolgend wir die Erfindung anhand von Zeichnungen näher beschrieben, auf denen sich auch unabhängig von der Zusammenfassung in den Patentansprüchen weitere Merkmale, Einzelheiten und Vorteile der Erfindung ergeben.

Es zeigen in schematischer Darstellung:
Fig. 1 einen Längsschnitt eines Reaktors mit zwei Elektroden in Draufsicht, wobei sich die Elektroden in einem verringerten Abstand zueinander befinden;
Fig. 2 einen Längsschnitt eines Reaktors analog der Darstellung in Fig. 1, jedoch zusätzlich mit einem Pumpenkanal;
Fig. 3 die Ansicht des in Fig. 2 gezeigten Reaktors, wobei die Elektroden sich in einem vergrößerten Abstand zueinander befinden und ein Substrat teilweise in den Reaktor eingebracht ist.
- Fig. 4 einen Längsschnitt einer Gegenelektrode und einer Gehäuserand eines Reaktors in Seitenansicht mit einer Lotrichtung L; -
Fig. 5 einen Greifarm eines Handlervorrichtung für flache Substrate in seitlicher Draufsicht;
Fig. 6 eine räumliche Darstellung einer Handlerbaugruppe mit einem Rahmengestellt und zwei Schächte;
Fig. 7 einen Schnitt einer Bearbeitungslinie in Draufsicht;
Fig. 8 eine räumliche Darstellung einer Bearbeitungslinie;
Fig. 9 eine räumliche Darstellung von Einzelheiten einer Bearbeitungslinie;
Fig. 10 einen Schnitt einer Bearbeitungslinie mit einem Shuttle;
Fig. 11 einen Längsschnitt eines Doppelprozessorraum-Reaktors in Draufsicht;

Die folgende Darstellung von Reaktoren, Handling, Vorrichtungen und Verfahren zur Bearbeitung von flachen Substraten focussieren auf konstruktive Aspekte, wobei es sich für den Fachmann versteht, dass diese Vorrichtungen und Verfahren mit im Einzelnen nicht dargestellten Sensoren, Heiz - und Kühlaggregate, Steuereinrichtungen und Antrieben versehen sind.

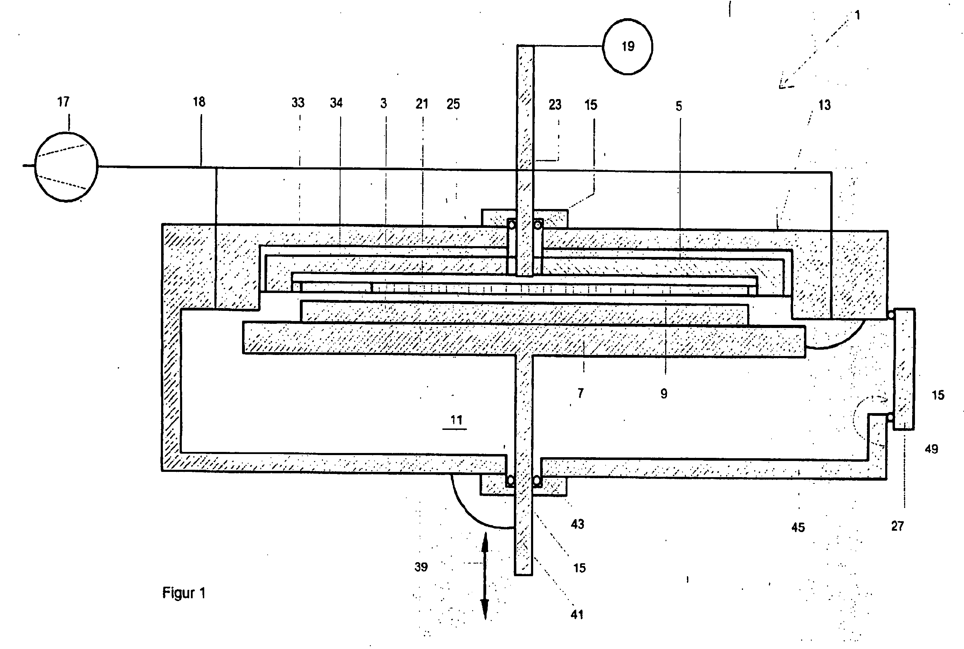

Fig. 1 zeigt in vereinfachter Darstellung einen Reaktor 1 zur Behandlung von flachen Substraten 3. Der Reaktor 1 kann beispielsweise als PECVD - Reaktor ausgelegt sein. Der Reaktor 1 umfasst einen Prozessraum 9 mit einer Elektrode 5 sowie einer Gegenelektrode 7, die zur Erzeugung eines Plasmas zur Behandlung einer zu behandelnden Oberfläche eines oder mehrerer flacher Substrate 3 ausgelegt sind. Die Elektroden 5, 7 können zur Erzeugung eines elektrischen Feldes in dem Prozessraum 9 an eine nicht näher dargestellte Spannungsquelle, vorzugsweise eine Hochfrequenz - Versorgungsquelle angeschlossen werden oder angeschlossen sein. Die Elektroden 5,7 sind vorzugsweise ausgelegt zur Behandlung von Substraten mit einer Fläche von mindestens 1,4 m² als Behandlungs- oder Bearbeitungsschritt bei der Herstellung von hocheffizienten Dünnschichtsolarmodulen, beispielsweise von amorphen oder mikrokristallinen Silizium - Dünnschicht - Solarzellen.

Die Elektroden 5,7 bilden zwei gegenüberliegende Wände des Prozessraumes 9. Der Prozessraum 9 befindet sich in einer Vakuumkammer 11, die eine Be- und Entladungsöffnung 49 aufweist, welche mit einer Verschlussvorrichtung 27 verschließbar ist. Die Verschlussvorrichtung ist optional. Die Vakuumkammer 11 wird durch ein Gehäuse 13 des Reaktors 1 gebildet. Zur Abdichtung gegenüber der Umwelt sind Dichtungen 15 vorgesehen.

Die Vakuumkammer 11 kann eine beliebige Raumform, beispielsweise mit einem runden oder mehreckigen, insbesondere rechteckigen Querschnitt aufweisen. Der Prozessraum 9 ist beispielsweise als flaches Parallelepiped ausgebildet.

Zum Einbringen und zum Entfernen von gasförmigen Material sind an sich bekannte Mittel vorgesehen, wobei es sich bei dem gasförmigen Material insbesondere um Beschichtungs - oder Reinigungsmaterial handelt. Das Reinigungsmaterial kann beispielsweise NF3 sein. Das Einbringen und Entfernen des gasförmigen Materials kann sowohl sequenziell als auch parallel erfolgen.

In Fig. 1 bis 2 sind als Mittel zum Entfernen von gasförmigem Material eine Vakuumpumpe 17 und zugeordnete Vakuumleitungen 18 dargestellt. Als Mittel zum Einbringen von gasförmigem Material ist eine Beschichtungsmaterialquelle 19 mit einem Kanal 23 vorgesehen, die an einem Gasverteiler 25 angeschlossen sind. Der Gasverteiler 25 ist in der vorliegenden Ausführungsform ähnlich einer Dusche ausgebildet und umfasst eine Vielzahl von in den Prozessraum 9 mündenden Durchbrüche durch die gasförmiges Material in den Prozessraum 9 eingebracht wird. Es versteht sich, dass die Mittel zum Einbringen von gasförmigem Material auch verschieden von der der Darstellung in Figur 1 ausgebildet sein können, ebenso wie der Gasverteiler 25.

Erfindungsgemäß weißt der Reaktor 1 eine Vorrichtung zum Variieren des relativen Abstandes zwischen den Elektroden auf, welche in der Ausführungsform der Fig. 1 bis 3 als Schiebebolzen 41 der mittels einer Lagerplatte 43 eine Linearbewegung in der Vakuumkammer 11 ausführen kann ausgebildet ist. Der Schiebebolzen ist mit der Elektrode 5 abgewandten Rückseite der Gegenelektrode 7 verbunden. Ein dem Schiebebolzen 41 zugeordneter Antrieb ist nicht dargestellt.

Die Elektrode 5 ist in einer Haltestruktur in der Vakuumkammer 11 angeordnet, die der Darstellung Fig. 1 bis 3 von der Gehäuserückwand 33 gebildet ist. Dazu ist die Elektrode 5 in einer Ausnehmung der Haltestruktur untergebracht und von der Vakuumkammerwand durch ein Dielektrikum 34 getrennt. Das Substrat 3 wird durch die Gegenelektrode 7 auf ihrer der Elektrode 5 zugewandten Vorderseite aufgenommen.

In der Darstellung der Fig. 1 ist ersichtlich, dass die Gegenelektrode 7 während der Durchführung der Behandlung die Ausnehmung abdeckt. Dabei wird zwischen einem Randbereich der Gegenelektrode 7 und einem Randbereich der Ausnehmung ein Spalt gebildet, der eine Breite in der Größenordnung von 1 mm aufweist. Die Spaltbreite ist derart dimensioniert, dass ein Plasma im inneren des Prozessraums während der Durchführung der Behandlung gehalten werden kann. Der Spalt führt dazu, dass zwischen dem Prozessraum und dem übrigen Innenraum der Vakuumkammer 11 kein allzu großes Druckgefälle aufgebaut wird. Durch die Vakuumleitungen 18 sind Bereiche der Vakuumkammer 11, die außerhalb des Prozessraums 9 angeordnet sind, mit der Vakuumpumpe 17 verbunden, so dass bei Betrieb der Vakuumpumpe 17 aufgrund des größeren Volumens auf eine einfache Weise eine hohe Homogenität der Gasflüsse aus dem Prozessraum 9 über den Spalt erreicht werden kann. Es versteht sich, dass auch andere - Konfigurationen der Mittel zum Entfernen zum gasförmigen Material aus den Prozessraum von der Erfindung umfasst werden.

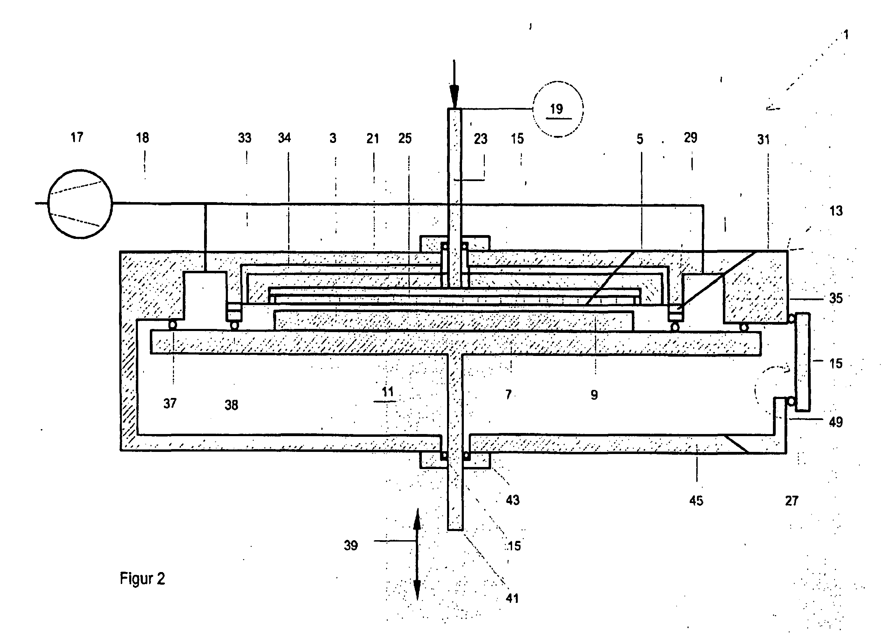

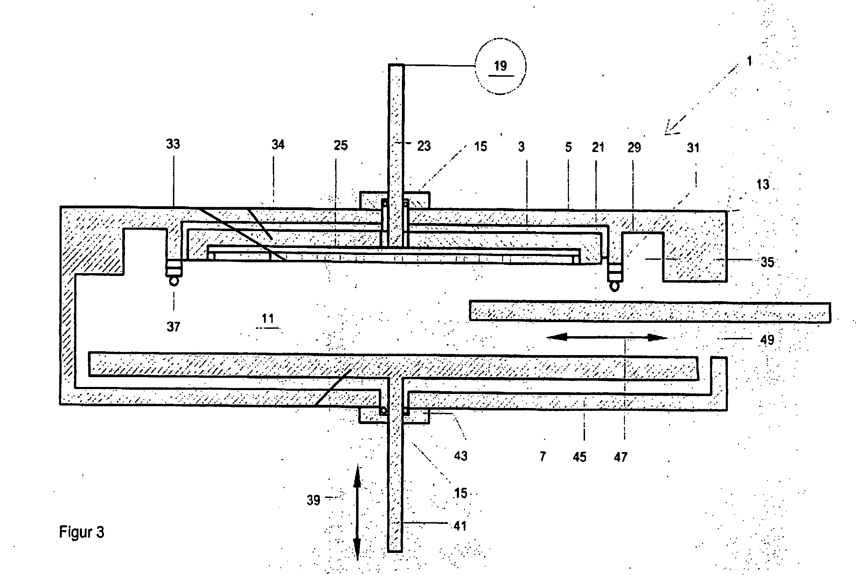

Fig. 2 und 3 zeigen einen weiteren Reaktor 1, analog dem in Fig. 1 dargestellten Reaktor 1. Im Folgenden wird lediglich auf die Unterschiede eingegangen.

Der Reaktor 1 gemäß Fig. 2 und 3 weist einen, vorzugsweise umlaufenden Pumpkanal 29 auf, der durcheine nutförmige zweite Ausnehmung in der Haltestruktur gebildet ist. Stromaufwärts ist der Pumpkanal 29 über Abpumpkanäle 31 mit dem Prozessraum 9 verbunden. Der Pumpkanal 29 ist ferner stromabwärts mit der Vakuumpumpe 17 über Vakuumleitungen 18 verbunden. Gegenüber der Vakuumkammer 11 ist der Pumpkanal bei einer Abdeckung der Ausnehmungen durch die Gegenelektrode 7 gasdicht abgetrennt oder abtrennbar. Hierzu sind vorzugsweise temperaturfesten Dichtungen 37 vorgesehen. Eine Abdeckung erfolgt vorzugsweise während der Durchführung der Behandlung des flachen Substrats. Dies ermöglicht vorteilhaft während einer Durchführung der Behandlung einen relativ hohen Arbeitsdruck von bis zu 10 mbar im Prozessraum 9 gegenüber einem Arbeitsdruck 10⁻² bis 10⁻⁴ mbar in der Prozesskammer.

Erfindungsgemäß ist in einer weiteren Ausführungsform vorgesehen, dass die Gegenelektrode 7 eine in den Fig. 1 bis 3 nicht dargestellte Vorrichtung zur Aufnahme von flachen Substraten aufweist, die derart ausgebildet ist, dass das oder die Substrate zumindest während der Durchführung der Behandlung der zu behandelnden oder behandelten Oberfläche nach unten orientiert mit einem Winkel Alpha in einem Bereich zwischen 0° und 90° gegenüber der Lotrichtung angeordnet sind. Bei einer derartigen Anordnung eines Substrats können Kontaminationen der zu beschichtenden oder beschichteten Oberfläche des Substrats vermieden oder zumindest reduziert werden, da die betreffenden Partikel im Schwerefeld nach unten und sich damit von der gefährdeten Oberfläche entfernen. Bevorzugt ist ein Wert des Winkels Alpha von 1 °, 3°, 5°, 7°, 9°, 11 °, 13°, 15°, 17°, 20°, 25°, 30°, 40°, 45°.

In Fig. 3 ist keine Verschlussvorrichtung 27 dargestellt, wobei das Substrat 3 teilweise durch die Öffnung 49 in den Prozessraum 9 des Reaktors 1 eingebracht ist. Ein Doppelpfeil 47 deutet die Belade- bzw. Endladebewegungsrichtung des Substrats 3 an. Es ist zu erkennen, dass durch die zurückgezogene Gegenelektrode, die sich nahe der Gehäusewand 45 des Gehäuses 13 befindet, das Substrat 3 besonders einfach in den Prozessraum 9 eingebracht werden kann, da dazu fast die gesamte räumliche Ausdehnung der Vakuumkammer 11 zur Verfügung steht.

Nach Einbringen des Substrats 3 in den Reaktor 1 kann das Substrat 3 durch die Gegenelektrode 7 auf ihrer der Elektrode 5 zugewandten Vorderseite aufgenommen werden.

Die Vorrichtung zur Aufnahme von Substraten kann ausgelegt sein für Substrate die mit einem Carrier versehen sind.

In einer bevorzugten Ausführungsform der Erfindung ist die Vorrichtung zur Aufnahme von Substraten zur rahmenlosen Aufnahme eines oder mehrerer Substrate bzw. für rahmenlose Carrier ausgelegt.

Die Vorrichtung zur Aufnahme von Substraten kann ferner ausgebildet sein zur Änderung des Abstandes zwischen dem aufzunehmenden oder aufgenommenen Substrat und der Oberfläche der Vorderseite der Gegenelektrode. Insbesondere kann das Substrat bei Be- oder Entladung des Prozessraums einen größeren Abstand von der genannten Oberfläche der Gegenelektrode aufweisen als bei Durchführung einer Behandlung.

Die Vorrichtung zur Aufnahme von Substraten kann zumindest in einem oberen Randbereich der Gegenelektrode 7 zumindest ein oberes Halteelement für ein oder mehrere Substrate und zumindest in einem unteren Bereich zumindest der Gegenelektrode 7 zumindest ein unteres Halteelement für ein oder mehrere Substrate aufweisen.

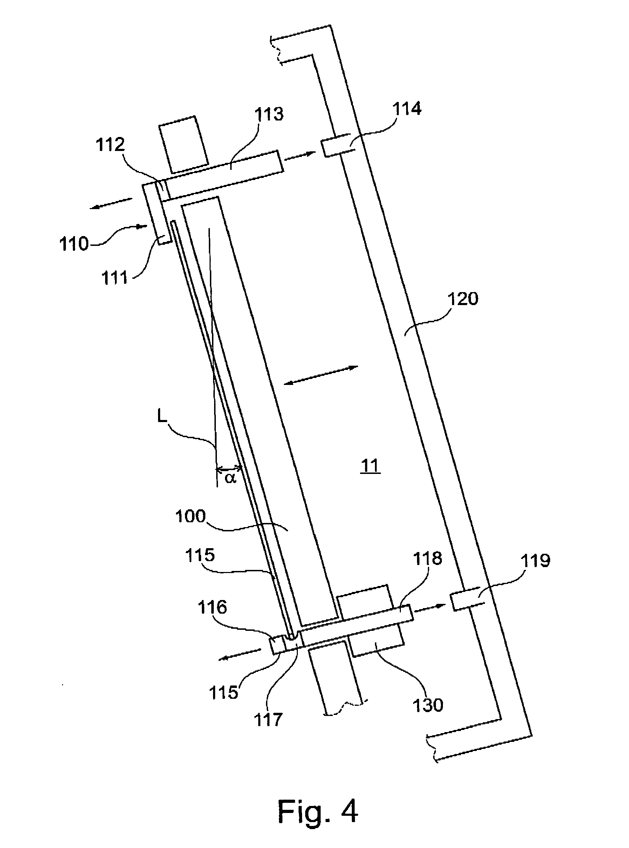

In Fig. 4 ist ein Längsschnitt einer Gegenelektrode 100 und einer Gehäusewand 120 eines erfindungsgemäßen Reaktors in Seitenansicht mit einer Lotrichtung L dargestellt mit einem Substrat 105, welches mit der zu behandelnden Oberfläche nach unten orientiert mit einem Winkel Alpha in einem Bereich zwischen 0° und 90° gegenüber der Lotrichtung angeordnet ist. Nicht dargestellt ist eine Elektrode, die der Gegenelektrode gegenüber angeordnet ist.

Das untere Halteelement ist als Auflageelement 115 für die untere Kante eines Substrats 105 ausgebildet. Das Auflageelement 115 ist dabei als Bolzen 118 mit einem metallischen Auflageteil 116, der in den in Fig. 4 nicht dargestellten Prozessraum hereinragt mit einem vorzugsweise aus einer Keramik bestehenden Zwischenstück 117 ausgebildet, wobei der Bolzen durch eine Durchführung in der Gegenelektrode 100 sich in einen Bereich der Vakuumkammer 11 auf der Rückseite der Gegenelektrode 120 erstreckt. Der Endbereich des Bolzens 118 kann bei dem Zurückziehen der Gegenelektrode 100 in Richtung auf die Gehäusewand 120 gegen einen Anschlag 119 drücken und damit aus der vorderseitigen Oberfläche der Gegenelektrode 100 in-Richtung auf den Prozessraum bewegt werden. Damit wird das Substrat 105 mit seiner unteren Kante von der vorderseitigen Oberfläche der Gegenelektrode 120 wegbewegt und nimmt daher einen größeren Abstand zu der genannten Oberfläche ein. Zumindest Teile des Bolzens 118 sind von einer Schutzhülle 130, die mit einem Inertgas, beispielsweise ein Stickstoff gefüllt werden kann, umgeben und erhöht den Korrosionsschutz in diesem Bereich, was insbesondere bei Einbringung von hoch korrosiven Reinigungsmitteln angezeigt ist

Das obere Halteelement ist als Gegenlager 110 mit einem metallischen Gegenlagerteil 111 für einen oberen Randbereich des Substrats 105 ausgebildet. Das Gegenlager ist mit einem Bolzen 113 verbunden, der durch eine Durchführung in der Gegenelektrode 100 in einen Bereich der Vakuumkammer 11 auf der Rückseite der Gegenelektrode 100 sich erstreckt. Ferner ist ein vorzugsweise aus einer Keramik bestehendes Zwischenstück 112 zwischen Gegenlagerteil 111 und dem Bolzen 113 vorgesehen. Der Bolzen 113 kann bei einem Zurückziehen der Gegenelektrode 100 in Richtung auf die Gehäusewand 120 gegen einen Anschlag 114 drücken und dabei eine Bewegung relativ von der vorderseitigen Oberfläche der Gegenelektrode 100 ausführen. Damit kann der Abstand zwischen den Substrat 105 und der vorderseitigen Oberfläche der Gegenelektrode 100 vergrößert werden. Durch die dargestellte Änderung des Abstandes zwischen Substrat 105 und der Oberfläche der Vorderseite der Gegenelektrode 100 wird eine sichere Be- und Entladung des Prozessraumes erreichbar, da das Substrat während Be- und Entladung gegenüber der Oberfläche der Vorderseite der Gegenelektrode 100 räumlich freigestellt ist.

Bei einer bevorzugten Ausführungsform der Erfindung werden ferner, wenn die Gegenelektrode 100 beispielsweise zur Durchführung der Behandlung eines Substrats in Richtung auf die Elektrode bewegt ist, die relativ zur Oberfläche der Vorderseite der Gegenelektrode linear bewegbaren Halteelemente gegen einen oder mehrere Anschläge gedrückt, die beispielsweise in einem beschichtungsfreien Randbereich einer Ausnehmung in der die Elektrode angeordnet ist, sich befinden. Damit wird der Abstand zwischen Substrat und Oberfläche der Vorderseite der Gegenelektrode verringert, vorteilhafter weise wird das Substrat gegen die genannte Oberfläche gedrückt, so dass eine Fixierung der Position des Substrats während der Durchführung der Behandlung erreicht werden kann. In einer weiteren Ausführungsform der Erfindung sind alternativ oder zusätzlich ein oder mehrere Halteelemente einem oder beiden Seitenbereichen des Substrats zugeordnet.

Ferner können die Halteelemente relativ zur Oberfläche der Vorderseite der Gegenelektrode schwenkbar bewegbar sein, um damit eine Be- oder Entladungsbewegung des Substrats zu erleichtern.

Da zumindest während der Behandlung, insbesondere während der Durchführung einer Beschichtung definierte Potentialverhältnisse im Prozessraum wichtig sind, sind die Halteelemente elektrisch floatend ausgebildet.

Bei einer Handlingvorrichtung für flache Substrate mit zumindest einem Greifarmmodul ist das Greifarmmodul derartig ausgebildet, dass die Substrate während der Be-und Entladung, beispielsweise eines Prozessraums mit einer zu behandelnden oder einer behandelnden Oberfläche nach unten orientiert mit einem Winkel Alpha in einem Bereich zwischen 0° und 90° gegenüber der Lotrichtung angeordnet sind. Der Winkel Alpha weist vorzugsweise einen Wert von 1°, 3°, 5°, 7°, 9°, 11°, 13°, 15°, 17°, 20°. 25°, 30°, 40°, 45° auf.

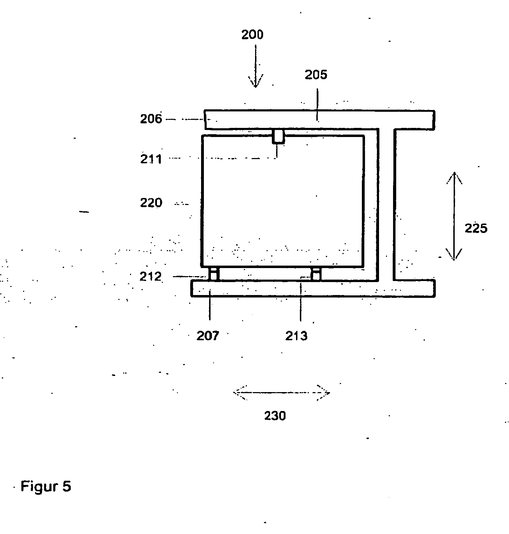

In Figur 5 ist ein Greifarm 200 dargestellt, der ein Rahmengestell 205 mit einer oberen und einer unteren Gabelzinke 206, 207 umfasst. An der oberen Gabelzinke 206 ist ein Gegenlager 211 und an der unteren Gabelzinke 207 sind Auflagen 212 und 213 für ein von dem Greifarm 200 gehaltertes Substrat 220 vorgesehen. Der Greifarm 200 ermöglicht eine rahmenlose Halterung des Substrats 220, wobei dieses auf einer seiner unteren Kanten stehend angeordnet ist. Das Rahmengestell kann vertikal parallel zum Pfeil 225 und horizontal parallel zum Pfeil 230 durch Antriebe bewegt werden. Mittels der Vertikalbewegung kann das Substrat 22U auf zumindest ein unteres Halteelement einer Halterung für Substrate aufgesetzt oder von diesem aufgenommen werden.

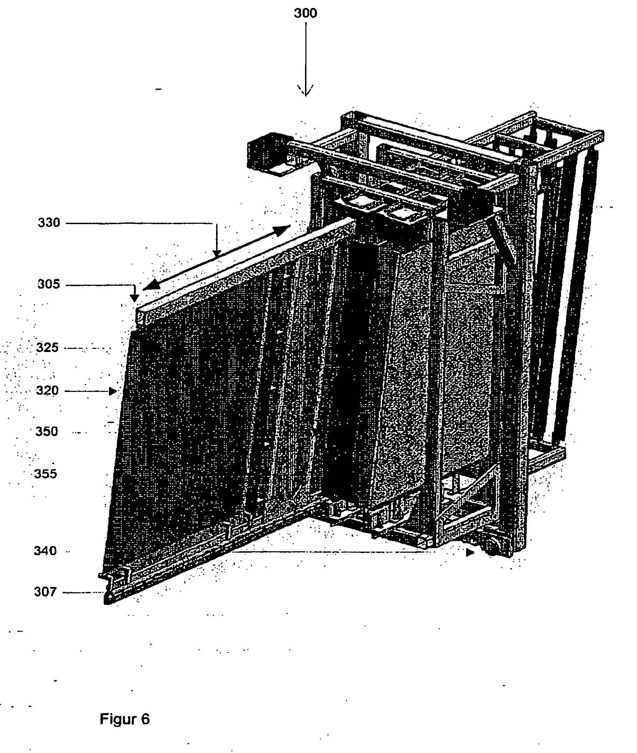

In Figur 6 ist perspektivisch eine Handlerbaugruppe 300 mit einem Rahmengestell 305 und einem Schacht 350 dargestellt.

Das Rahmengestellt ist in den Schacht 350 ein- und ausfahrbar parallel zur Richtung des Pfeils 330. Ferner weist die Handlerbaugruppe 300 einen zweiten Schacht 355 auf mit einem weiteren nicht sichtbaren Rahmengestellt. Ein Substrat 320 ist Analog zu der Darstellung in Figur 5 im Bereich zwischen der Gabelzinke 306 und der Gabelzinke 307 angeordnet. Ferner weist der Handler eine Heizkompomente 325 zur Temperierung von Substraten zumindest in den Schacht 350 eingefahrenes Rahmengestell 305 auf. Die Handlerbaugruppe weist ferner Räder 340 auf, mit denen ihrer Verfahrbarkeit gewährleistet wird. Neben einer Bewegung des Rahmengestells 305 parallel zur Richtung des Pfeils 330 ist eine Vertikalbewegung des Rahmengestells 305 möglich. Die zur Durchführung der Bewegung des Rahmengestells erforderlichen Antriebsaggregate sind in den Figuren 5 und 6 nicht dargestellt.

Bevorzugt ist eine Handlingvorrichtung einem erfindungsgemäßen Reaktor zugeordnet. Dabei erfolgt eine Be- oder Entladung des Prozessraums des Reaktors durch eine Kombination einer Bewegung des Greifarms parallel zur Oberfläche des in den Prozessraum einzubringenden oder zu entfernenden Substrats in horizontaler bzw. vertikaler Richtung. Vorzugsweise wird, wie im Zusammenhang mit Figur 4 -dargestellt wurde, während einer Be- oder Entladung der Abstand zwischen dem Substrat und der Oberfläche der Vorderseite der Gegenelektrode relativ groß gehalten und das Substrat auf zumindest ein unteres Halteelement der Vorrichtung zur Aufnahme von Substraten abgesetzt oder von dem unterem Halteelement aufgenommen.

Bei einer Handlingvorrichtung mit einem ersten und einem zweiten Greifarm kann auf eine einfache Weise ein Austausch eines in einem Reaktor behandelten Substrats durch ein zweites Substrat erfolgen. Hierbei wird ein erstes Substrat aus dem Reaktor entladen, in die Handlingvorrichtung eingeführt und anschließend ein bereits in der Handlingvorrichtung vorhandenes zweites Substrat in den Reaktor eingeführt. Hierbei ist lediglich eine Bewegung der Handlingvorrichtung relativ zu dem Reaktor erforderlich um eine korrekte Positionierung des Greifarms gegenüber der Be- und Entladungsöffnung zu gewährleisten.

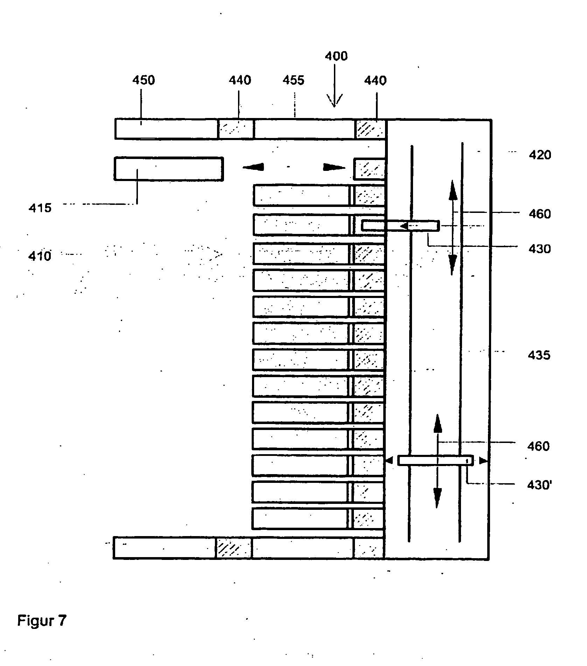

Eine erfindungsgemässe Vorrichtung zur Bearbeitung von flachen Substraten ist in Fig. 7 in einer Schnittdarstellung in Draufsicht dargestellt.

Die Fig. 7 zeigt dabei eine Bearbeitungslinie 400 mit einem als Tunnel 420 ausgebildeten Transportraum mit einer Reihe von als Reaktoren 410 ausgebildeten Prozessrezipienten zur Behandlung von flachen Substraten die mit dem Tunnel 420 verbunden sind.

In dem, vorzugsweise temperierten Tunnel 420 befindet sich ein Roboter 430 der zur Verdeutlichung auch an einer zweiten Position im Tunnel 420, dort mit dem Bezugszeichen 430' bezeichnet, dargestellt ist. Der Roboter 430 ist auf einer Führungsschiene 435 angeordent. Ferner sind beim Eingang der Bearbeitungslinie zwei Heizmodule 450 und 455 vorgesehen, wobei das Heizmodul 450 beispielsweise eine Heizung bei atmosphärischen Druck ermöglicht. Die Prozessrezipienten bzw. Reaktoren 410 sind mit Ventilen 440 mit dem Tunnel verbunden. Der Tunnel 420 ist evakuierbar und/oder mit einem Inertgas, beispielsweise Stickstoff oder Argon oder dergleichen befüllbar. Mit 415 ist ein von dem Tunnel abgetrennter Reaktor bezeichnet.

Eine Bearbeitungslinie wie in Fig. 7 ist insbesondere zur Bearbeitung von Substraten für Dünnschichtsolarzellen geeignet. Eine deratige Dünnschichtsolarzelle besteht aus P- i - n - Schichten aus amorphen Silizium und P-I-N-Schichten aus mikrokristallieden Silizium. Vorzugsweise werden die Dotierschichten und die intrinsischen Schichten in unterschiedlichen Prozessrezipienten abgeschieden um eine Verschleppung Dotierstoffen, die die Effizienz der intrinsischen Schichten negativ beeinflussen könnte, zu verhindern. Die dargestellte Bearbeitungslinie ermöglicht ein hocheffektives Parallelprozessieren. -

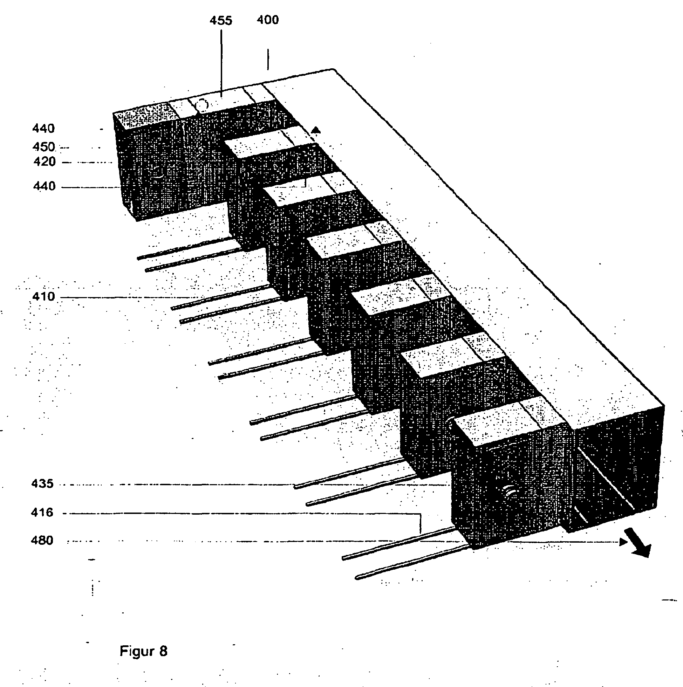

In Fig. 8 ist eine räumliche Darstellung der Bearbeitungslinie von Fig. 7 gezeigt, wobei erkennbar ist, daß die als an- und abkoppelbare Module ausgebildeten Reaktoren 410 auf Schienen 416 verfahrbar angeordnet sind, um einen Stillstand der Bearbeitungslinie zu minimieren. Bei Wartung oder im Störungsfall können die Reaktoren vom Tunnel abgekoppelt werden, ohne die verbleibenden Prozesse zu unterbrechen.

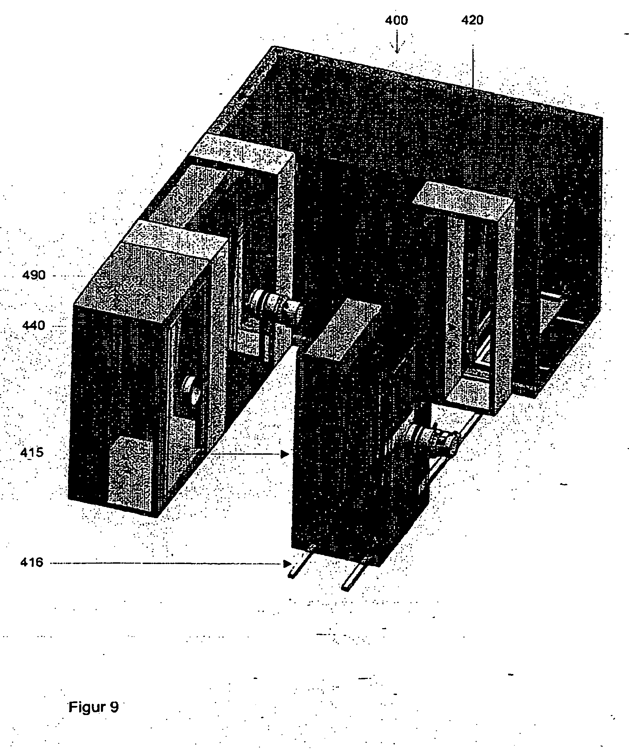

In Fig. 9 ist für eine Bearbeitungslinie 400 ein Zustand mit einem abgekoppelten Reaktor 415 genauer illustriert. Zur Veranschaulichung ist dabei das Ventil 440 geöffnet, so daß ein Substrat 490, welches sich in dem Tunnel auf einem Roboter befindet erkennbar ist.

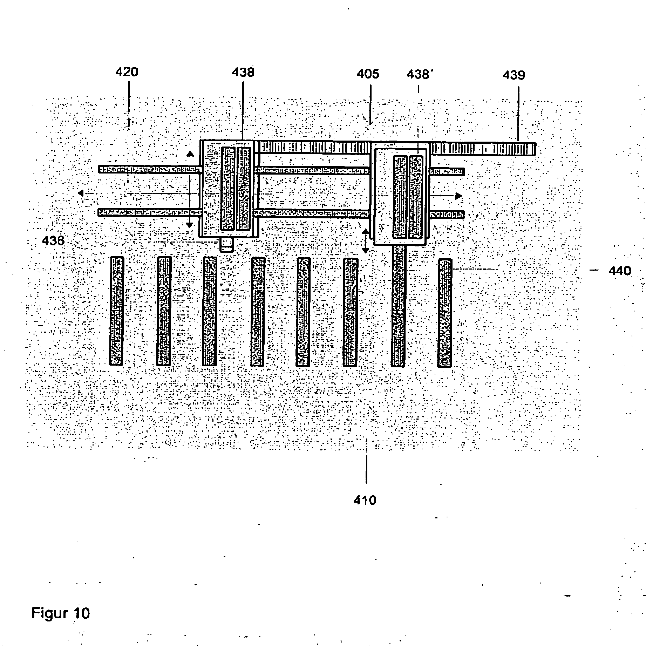

In Figur 10 ist eine Ausführungsform einer Vorrichtung zur Bearbeitung von flachen Substraten dargestellt, bei der der Transportroboter als Shuttle 438 bzw. 438' mit einem Vakuumrezipienten und einer in diesen angeordneten Handlingvorrichtung für flache Substrate ausgebildet ist. Der Shuttle weist ein Ventil 436 auf mit dem er mit den Prozessrezipienten 410 Vakuumtechnisch verbunden werden kann. Bei dieser Ausführungsform ist der Transportraum vorzugsweise nicht evakuierbar ausgebildet. Eine derartige Ausführungsform ist insbesondere für sehr große Substrate geeignet, da das zu evakuierende Volumen gering gehalten werden kann. Zur Verbindung des Shuttle 438 mit Leistungs- und Medienversorgungen kann eine Schleppkette 439 vorgesehen sein. In einer Ausführungsform weist der Shuttle 438 einen eigenen vorzugsweise kleineren Pumpstand auf, der mit dem Vakuumrezipienten beispielsweise auf einer Grundplatte angeordnet ist. Bei einer Ankopplung des Shuttle 438 bzw. des Vakuumrezipienten an einen Prozessrezipienten, kann das sich zwischen den beiden Ventilen befindliche Zwischenvolumen über eine eigene Pumpe oder über ein Dosierventil über die gegebenenfalls vorhandene Shuttlepumpe abgepumpt werden.

Vorteilhaft ist, wenn Sensoren vorgesehen sind die Relativposition des im Vakuumrezipienten angeordneten Handlers und/oder diesen zugeordneten Substraten gegenüber der Elektrode oder Gegenelektrode in einem Prozessrezipienten zu ermitteln. Über eine Steuerung kann dann eine korrekte Ankopplung für die Be- und Entladung des Prozessrezipienten mit einem Substrat gesteuert werden.

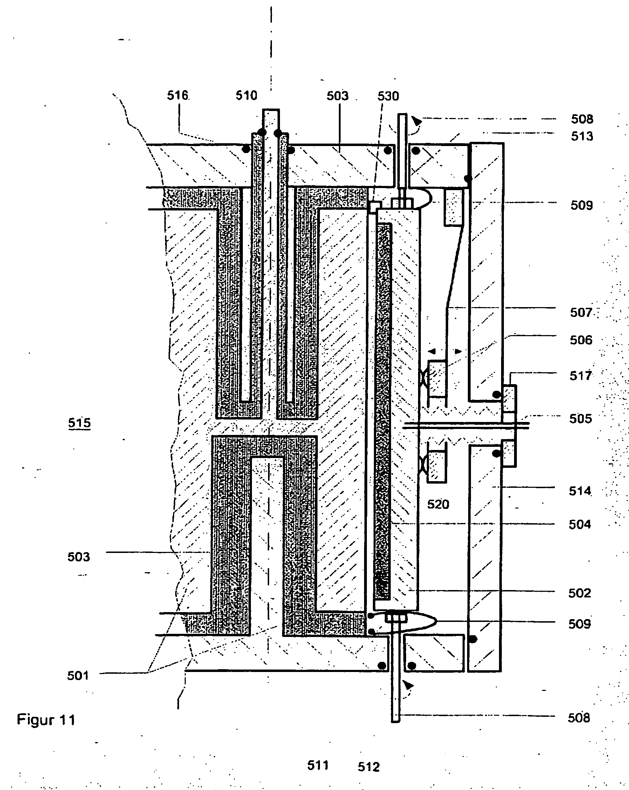

In Fig. 11 ist in einer Schnittdarstellung in Draufsicht ein weiterer Reaktor zur Behandlung von flachen Substraten dargestellt, mit einer ersten Vakuumkammer 520, in der ein erster Prozessraum 530 angeordnet ist; mit einer ersten Elektrode 501 und einer ersten Gegenelektrode 502 zur Erzeugung eines Plasmas zur Behandlung einer zu behandelnden Oberfläche, wobei die erste Elektrode 501 und die erste Gegenelektrode 502 zwei gegenüberliegende Wände des Prozessraumes 520 bilden.

Ferner ist eine Vorrichtung zum Variieren des relativen Abstandes zwischen den Elektroden vorgesehen, wobei ein erster relativ großer Abstand bei einer Be- oder Entladung der Prozessraums 520 mit einem Substrat und ein zweiter relativ geringer Abstand bei Durchführung der Behandlung des zumindest einen Substrats vorgesehen ist.

Die Vorrichtung zum Variieren des relativen Abstandes zwischen den Elektroden umfast Exenter 512 über die Drehantriebe 508 eine Parallelverschiebung der Gegenelektrode 502 bewirken können. Ferner sind Tellerfedern 506 vorgesehen, die eine Taumelbewegung der Gegenelektrode 502 zulassen, wobei die Taumelbewegung durch die Exenterantriebe 512 begrenzt ist. Ferner ist eine der Gegenelektrode zugeordnete Vorrichtung zur Aufnahme von Substraten vorgesehen, die analog der bereits dargestellten Vorrichtung ist, in Fig. 11 jedoch nicht in Einzelheiten gezeigt ist.

Der Reaktor 500 umfasst ferner eine zweite Vakuumkammer in der ein zweiter Prozessraum angeordnet ist, wobei eine zweite Elektrode und eine zweite Gegenelektrode zur Erzeugung eines Plasmas zur Behandlung einer zu behandelnden Oberfläche vorgesehen sind, die jeweils zwei gegenüberliegende Wände des zweiten Prozessraumes bilden. Die zweite Vakuumkammer mit dem zweiten Prozessraum ist analog der ersten Vakuumkammer mit dem ersten Prozessraum ausgebildet und auf der Rückseite der ersten Elektrode angeordnet, d.h. auf der der ersten Gegenelektrode gegenüber liegenden Seite der ersten Elektrode. Bevorzugt ist die zweite Vakuumkammer spiegelbildlich zur ersten ausgebildet. Die zweite Vakuumkammer beinhaltet ferner einen Vorrichtung zum Variieren des Abstandes zwischen Elektrode und Gegenelektrode. Ferner umfasst der Reaktor 500 eine Hochfrequenzzuführung 510, ein Gehäuseband 511, einen keramischer Anschlag 513, eine Gehäusetür 514 sowie Dichtungen 516 und einen Vakuumbalg 517.

### Bezugszeichenliste

- 1: Reaktor
- 3: Substrat
- 5: erste Elektrode
- 7: zweite Elektrode
- 9: Prozessraum
- 11: Vakuumkammer
- 13: Gehäuse
- 15: Dichtung
- 17: Vakuumpumpe
- 18: Vakuumleitungen
- 19: Beschichtungsmaterialquelle
- 21: Oberfläche
- 23: Kanal
- 25: Gasverteiler
- 27: Verschlussvorrichtung
- 29: Pumpkanal
- 31: Abpumpkanäle
- 33: Gehäuserückwand
- 34: Dilektrikum
- 35: Nut
- 37: Dichtringe
- 38: Dichtringe
- 39: Doppelpfeil
- 41: Schiebebolzen
- 43: Lagerplatte
- 45: Gehäusewand
- 47: Doppelpfeil
- 49: Öffnung
- 100: Gegenelektrode
- 105: Substrat
- 110: Gegenlager
- 111: Gegenlagerteil
- 112: Zwischenstück
- 113: Bolzen
- 114: Anschlag
- 115: Auflageelement
- 116: Auflagenteil
- 117: Zwischenstück
- 118: Bolzen
- 119: Anschlag
- 120: Gehäusewand
- 130: Schutzhülle
- 200: Greifarm
- 205: Rahmegestell
- 206: Gabelzinke
- 207: Gabelzinke
- 211: Gegenlager
- 212: Auflage
- 213: Auflage
- 220: Substrat
- 225: Pfeil
- 230: Pfeil
- 300: Handierbaugruppe
- 305: Rahmengestellt
- 306: Gabelzinke
- 307: Gabelzinke
- 320: Substrat
- 325: Heizkomponente
- 330: Pfeil
- 340: Räder
- 350: Schacht
- 355: Schacht
- 400: Bearbeitungslinie
- 405: Bearbeitungslinie
- 410: Reaktoren
- 415: abgetrennter Reaktor
- 416: Schienen
- 420: Tunnel
- 430: Roboter
- 430': Roboter
- 435: Führungsschiene
- 436: Ventil
- 439: Pleppkette
- 440: Ventil
- 450: Heizmodul
- 455: Heizmodul
- 460: Pfeil
- 470: Pfeil
- 480: Pfeil
- 490: Substrat
- 500: Reaktor
- 501: Elektroden
- 502: Gegenelektrode
- 503: Dielektrikum
- 504: Substrat
- 505: Zu- und Abfuhrleitungen
- 506: Tellerfedern
- 507: Flachbandaufhängung
- 508: Drehantriebe
- 509: Hochfrequenzkontaktbänder
- 510: Hochfrequenzzuführung
- 511: Gehäuseband
- 512: Excenter
- 513: keramischer Anschlag
- 514: Gehäusetür
- 515: zweite Hälfte des Reaktors
- 516: Dichtungen
- 517: Vakuumbalg

## Patentansprüche

1. Reaktor (1) zur Behandlung von flachen Substraten (3), insbesondere zur Beschichtung von flachen Substraten (3) mit einem Beschichtungsmaterial, mit
- einer Vakuumkammer (11), in der ein Prozessraum (9) angeordnet ist, wobei eine erste Elektrode (5) und eine Gegenelektrode (7) zur Erzeugung eines Plasmas zur Behandlung einer zu behandelnden Oberfläche vorhanden sind und zwei gegenüberliegende Wände des Prozessraums (9) bilden
- Mitteln zum Einbringen und Mitteln zur Entfernung von gasförmigen Material, insbesondere Beschichtungs- und/oder Reinigungsmaterial in den und/oder aus dem Prozessraum (9)
- wobei das zumindest eine Substrat (3) durch die Gegenelektrode (7) auf ihrer der Elektrode (5) zugewandten Vorderseite aufnehmbar ist
- einer Be-und Entladungsöffnung der Vakuumkammer (11), vorzugsweise mit einer Verschlussvorrichtung (27),
wobei eine Vorrichtung zum Variieren des relativen Abstandes zwischen den Elektroden (5; 7) vorhanden ist, wobei ein erster relativ großer Abstand bei einer Be- oder Entladung der Prozesskammer (9) mit dem zumindest einen Substrat und ein zweiter relativ geringer Abstand bei Durchführung der Behandlung des zumindest einen Substrats vorhanden ist
**dadurch gekennzeichnet, dass**
eine Haltestruktur (33) in der Vakuumkammer (11) für die Elektrode (5) vorgesehen und die Elektrode (5) in einer Ausnehmung der Haltestruktur (33) angeordnet ist, dass die Gegenelektrode (7) während der Durchführung der Behandlung die Ausnehmung abdeckt wobei zwischen einem Randbereich der Gegenelektrode (7) und einem Randbereich der Ausnehmung ein Spalt gebildet ist, der derart dimensioniert ist, dass ein im Prozessraum (9) erzeugtes Plasma innerhalb des Prozessraums (9) gehalten wird oder haltbar ist

2. Reaktor (1) nach Anspruch 1, **dadurch gekennzeichnet, dass** zumindest eine der Elektroden einen Gasverteiler für Beschichtungsmaterial und/oder Reinigungsmaterial aufweist.

3. Reaktor (1) nach Anspruch 1 oder 2, **dadurch gekennzeichnet, dass** eine der Gegenelektrode (7) zugeordnete Vorrichtung zur Aufnahme von Substraten (3) vorhanden ist, die derart ausgebildet ist, dass das zumindest eine Substrat (3) zumindest während der Durchführung der Behandlung mit der zu behandelnden Oberfläche nach unten mit einem Winkel Alpha in einem Bereich zwischen 1° und 45° gegenüber der Lotrichtung angeordnet ist

4. Reaktor (1) nach einem der vorhergehenden Ansprüche, **dadurch gekennzeichnet, dass** der Vakuumkammer (11) eine Handlingvorrichtung zur Be- und Entladung des Prozessraums (9) mit zumindest einem Substrat (3) zugeordnet ist, wobei die Handlingvorrichtung derart ausgebildet ist, dass das zumindest eine Substrat (3) zumindest während der Be- und Entladung des Prozessraumes (9) mit der zu behandelnden Oberfläche nach unten mit einem Winkel Alpha in einem Bereich zwischen 0 °und 30° gegenüber der Lotrichtung angeordnet ist

5. Reaktor (1) nach einem der Ansprüche 3 bis 4, **dadurch gekennzeichnet, dass** die Vorrichtung zur Aufnahme von Substraten (3) mit einem Carrierrahmen oder zur rahmenlosen Aufnahme eines oder mehrerer Substrate (3) ausgelegt ist

6. Reaktor (1) nach einem der Ansprüche 3 bis 5, **dadurch gekennzeichnet, dass** die Vorrichtung zur Aufnahme von Substraten zur Änderung des Abstandes zwischen dem Substrat (3) und der Oberfläche der Vorderseite der Gegenelektrode (7) ausgebildet ist

7. Reaktor (1) nach einem der Ansprüche 3 bis 6, **dadurch gekennzeichnet, dass** die Vorrichtung zur Aufnahme von Substraten (3) zumindest in einem oberen Randbereich zumindest ein oberes Halteelement für ein oder mehrere Substrate (3) und zumindest in einem unteren Bereich zumindest ein unteres Halteelement für ein oder mehre Substrate (3) aufweist

8. Reaktor (1) nach Anspruch 7, **dadurch gekennzeichnet dass** das obere Halteelement als Gegenlager für obere Randbereiche eines oder mehrerer Substrate (3) ausgebildet ist

9. Reaktor (1) nach Anspruch 7 oder 8. **dadurch gekennzeichnet, dass** das untere Halteelement als Auflageelement (115) für die untere Kante eines oder mehrerer Substrate (3) ausgebildet ist

10. Reaktor (1) nach einem der Ansprüche 7 bis 9, **dadurch gekennzeichnet dass** das obere und/oder untere Halteelement relativ zur genannten Oberfläche der Gegenelektrode (7) linear und/oder schwenkbar bewegbar ist.

11. Reaktor(1) nach einem der einem der Ansprüche 7 bis 10, **dadurch gekennzeichnet, dass** die Halteelemente ausgebildet sind zur Änderung des Abstandes zwischen dem Substrat (3) und der genannten Oberfläche der Gegenelektrode (7).

12. Reaktor (1) nach mindestens einem der Ansprüche 7 bis 11, **dadurch gekennzeichnet, dass** die Halteelemente elektrisch floatend ausgebildet sind.

13. Reaktor (1) nach einem der vorhergehenden Ansprüche, **dadurch gekennzeichnet dass** die in einer Ausnehmung der Haltestruktur (33) untergebrachte Elektrode (5) von der Vakuumkammerwand durch ein Dielektrikum getrennt ist

14. Reaktor (1) nach einem der vorhergehenden Ansprüche, **dadurch gekennzeichnet, dass** der Reaktor (1) eine Handlingvorrichtung (300) für flache Substrate mit zumindest einem Greifammodul für ein oder mehrere Substrate aufweist, wobei das Greifammodul (200) derart ausgebildet ist, dass die Substrate (3) parallel zu ihrer Oberfläche bewegbar sind und zumindest während der Be- und Entladung eines Prozessraums (9) mit einer zu behandelnden Oberfläche nach unten mit einem Winkel Alpha in einem Bereich zwischen 1° und 45° gegenüber der Lotrichtung angeordnet sind.

15. Verfahren zur Behandlung von flachen Substraten (3), insbesondere zur Beschichtung von flachen Substraten mit einem Beschichtungsmaterial in einem Reaktor mit
- einer Vakuumkammer (11), in der ein Prozessraum (9) angeordnet ist, wobei eine erste Elektrode (5) und eine Gegenelektrode (7) zur Erzeugung eines Plasmas zur Behandlung einer zu behandelnden Oberfläche vorgesehen sind und zwei gegenüberliegende Wände des Prozessraums (9) bilden
- Mitteln zum Einbringen und Mitteln zur Entfernung von gasförmigen Material, insbesondere Beschichtungs- oder Reinigungsmaterial in den oder aus dem Prozessraum (9)
- wobei das zumindest eine Substrate (3) von der Gegenelektrode (7) auf ihrer Vorderseite aufnehmbar ist
- einer Be- und Entladungsöffnung der Vakuumkammer (11), vorzugsweise mit einer Verschlussvorrichtung (27)
wobei der relative Abstand zwischen den Elektroden (5;7) einstellbar ist und ein erster relativ großer Abstand bei einer Be- oder Entladung der Prozesskammer (9) mit dem zumindest einen Substrat (3) und ein zweiter relativ geringer Abstand bei Durchführung der Beschichtung des zumindest einen Substrats (3) vorhanden ist, **dadurch gekennzeichnet dass**
eine Haltestruktur (33) in der Vakuumkammer (11) für die Elektrode (5) vorhanden und die Elektrode (5) in einer Ausnehmung der Haltestruktur (33) angeordnet wird, dass die Gegenelektrode (7) während der Durchführung der Behandlung die Ausnehmung abdeckt, wobei zwischen einem Randbereich der Gegenelektrode (7) und einem Randbereich der Ausnehmung ein Spalt gebildet wird, der derart dimensioniert ist, dass ein im Prozessraum (9) erzeugtes Plasma innerhalb des Prozessraums (9) gehalten wind oder haltbar ist

## Claims

1. Reactor (1) for the treatment of flat substrates (3), in particular for the coating of flat substrates (3) with a coating material, comprising
- a vacuum chamber (11) with a process space (9) arranged therein, wherein a first electrode (5) and a counterelectrode (7) are present for generating a plasma for the treatment of a surface to be treated and form two opposite walls of the process space (9),
- means for introducing and means for removing gaseous material, in particular coating and/or cleaning material, into and/or from the process space (9),
- wherein the at least one substrate (3) can be accommodated by the counterelectrode (7) on the latter's front side facing the electrode (5),
- a loading and unloading opening of the vacuum chamber (11), preferably with a closure device (27),
wherein a device for varying the relative distance between the electrodes (5; 7) is present, wherein a first, relatively large distance is present when loading or unloading the process chamber (9) with the at least one substrate and a second, relatively small distance is present when carrying out the treatment of the at least one substrate
**characterized in that**
provision is made of a holding structure (33) in the vacuum chamber (11) for the electrode (5) and the electrode (5) is arranged in a cutout of the holding structure (33), **in that** the counterelectrode (7) covers the cutout during the performance of the treatment, wherein a gap is formed between an edge region of the counterelectrode (7) and an edge region of the cutout, said gap being dimensioned such that a plasma generated in the process space (9) is held or can be held within the process space (9).

2. Reactor (1) according to Claim 1, **characterized in that** at least one of the electrodes has a gas distributor for coating material and/or cleaning material.

3. Reactor (1) according to Claim 1 or 2, **characterized in that** a device which is assigned to the counterelectrode (7) and is intended for accommodating substrates (3) is present, which is embodied in such a way that the at least one substrate (3) is arranged at an angle alpha in a range of between 1° and 45° relative to the perpendicular direction at least during the performance of the treatment with the surface to be treated facing downward.

4. Reactor (1) according to one of the preceding claims, **characterized in that** the vacuum chamber (11) is assigned a handling device for loading and unloading the process space (9) with at least one substrate (3), wherein the handling device is embodied in such a way that the at least one substrate (3) is arranged at an angle alpha in a range of between 0° and 30° relative to the perpendicular direction at least during the loading and unloading of the process space (9) with the surface to be treated facing downward.

5. Reactor (1) according to either of Claims 3 and 4, **characterized in that** the device for accommodating substrates (3) is designed with a carrier frame or for framelessly accommodating one or a plurality of substrates (3).

6. Reactor (1) according to any of Claims 3 to 5, **characterized in that** the device for accommodating substrates is designed for changing the distance between the substrate (3) and the surface of the front side of the counterelectrode (7).

7. Reactor (1) according to any of Claims 3 to 6, **characterized in that** the device for accommodating substrates (3) has at least one upper holding element for one or a plurality of substrates (3) at least in an upper edge region and at least one lower holding element for one or a plurality of substrates (3) at least in a lower region.

8. Reactor (1) according to Claim 7, **characterized in that** the upper holding element is embodied as a counterbearing for upper edge regions of one or a plurality of substrates (3).

9. Reactor (1) according to Claims 7 or 8, **characterized in that** the lower holding element is embodied as a bearing element (115) for the lower edge of one or a plurality of substrates (3).

10. Reactor (1) according to any of claims 7 to 9, **characterized in that** the upper and/or lower holding element can be moved linearly and/or in a pivotable fashion relative to said surface of the counterelectrode (7).

11. Reactor (1) according to any of Claims 7 to 10, **characterized in that** the holding elements are designed for changing the distance between the substrate (3) and said surface of the counterelectrode (7).

12. Reactor (1) according to at least one of Claims 7 to 11, **characterized in that** the holding elements are designed to be electrically floating.

13. Reactor (1) according to any of the preceding claims, **characterized in that** the electrode (5) which is accommodated in a cutout of the holding structure (33) is separated from the vacuum chamber wall by a dielectric.

14. Reactor (1) according to any of the preceding claims, **characterized in that** the reactor (1) has a handling device (300) for flat substrates comprising at least one gripping arm module for one or a plurality of substrates, wherein the gripping arm module (200) is embodied in such a way that the substrates (3) can be moved parallel to the surface thereof and are arranged at an angle alpha in a range of between 1° and 45° relative to the perpendicular direction at least during the loading and unloading of a process space (9) with a surface to be treated facing downward.

15. Method for the treatment of flat substrates (3), in particular for the coating of flat substrates with a coating material, in a reactor comprising
- a vacuum chamber (11) with a process space (9) arranged therein, wherein a first electrode (5) and a counterelectrode (7) are provided for generating a plasma for the treatment of a surface to be treated and form two opposite walls of the process space (9),
- means for introducing and means for removing gaseous material, in particular coating or cleaning material, into or from the process space (9),
- wherein the at least one substrate (3) can be accommodated by the counterelectrode (7) on the latter's front side,
- a loading and unloading opening of the vacuum chamber (11), preferably with a closure device (27),
wherein the relative distance between the electrodes (5; 7) is adjustable and a first, relatively large distance is present when loading or unloading the process chamber (9) with the at least one substrate (3) and a second, relatively small distance is present when carrying out the coating of the at least one substrate (3), **characterized in that**
a holding structure (33) is present in the vacuum chamber (11) for the electrode (5) and the electrode (5) is arranged in a cutout of the holding structure (33), **in that** the counterelectrode (7) covers the cutout during the performance of the treatment, wherein a gap is formed between an edge region of the counterelectrode (7) and an edge region of the cutout, said gap being dimensioned such that a plasma generated in the process space (9) is held or can be held within the process space (9).

## Revendications

1. Réacteur (1) destiné à traiter des substrats plats (3), en particulier à revêtir des substrats plats (3) par un matériau de revêtement, le réacteur présentant
une chambre sous vide (11) dans laquelle est disposé un espace de traitement (9), une première électrode (5) et une électrode complémentaire (7) étant prévues pour former un plasma de traitement d'une surface à traiter et formant deux parois opposées de l'espace de traitement (9),
des moyens d'amenée et des moyens d'enlèvement d'un matériau gazeux, en particulier d'un matériau de revêtement et/ou d'un matériau de nettoyage, dans l'espace de traitement (9) ou hors de ce dernier,
le ou les substrats (3) pouvant être repris par le côté avant, tourné vers l'électrode (5), de l'électrode complémentaire (7),
une ouverture de chargement et de déchargement de la chambre sous vide (11), de préférence dotée d'un dispositif de fermeture (27),
un dispositif permettant de modifier la distance relative entre les électrodes (5; 7) étant prévu, une première distance relativement grande étant prévue lors du chargement ou du déchargement du ou des substrats dans la chambre de traitement (9) et une deuxième distance, relativement petite, étant prévue lors de l'exécution du traitement du ou des substrats, **caractérisé en ce que**
une structure de maintien (33) est prévue pour l'électrode (5) dans la chambre sous vide (11) et l'électrode (5) est disposée dans une découpe de la structure de maintien (33),
**en ce que** l'électrode complémentaire (7) recouvre la découpe pendant l'exécution du traitement et
un interstice, dimensionné de telle sorte que le plasma formé dans l'espace de traitement (9) soit maintenu ou puisse être maintenu à l'intérieur de l'espace de traitement (9), étant formé entre la bordure de l'électrode complémentaire (7) et la bordure de la découpe.

2. Réacteur (1) selon la revendication 1, **caractérisé en ce qu'**au moins l'une des électrodes présente un répartiteur de gaz pour le matériau de revêtement et/ou le matériau de nettoyage.

3. Réacteur (1) selon les revendications 1 ou 2, **caractérisé en ce qu'**un dispositif associé à l'électrode complémentaire (7) et prévu pour reprendre des substrats (3) est prévu et configuré de telle sorte qu'au moins pendant l'exécution du traitement, le ou les substrats (3) soient disposés avec la surface à traiter orientée vers le bas sous un angle alpha compris dans la plage de 1° à 45° par rapport à la verticale.

4. Réacteur (1) selon l'une des revendications précédentes, **caractérisé en ce qu'**un dispositif de manipulation permettant de charger et de décharger le ou les substrats (3) dans l'espace de traitement (9) est associé à la chambre sous vide (11), le dispositif de manipulation étant configuré de telle sorte qu'au moins pendant le chargement et le déchargement de l'espace de traitement (9), le ou les substrats (3) soient disposés avec leur surface à traiter orientée vers le bas sous un angle alpha compris entre 0° et 30° par rapport à la verticale.

5. Réacteur (1) selon l'une des revendications 3 à 4, **caractérisé en ce que** le dispositif de reprise de substrat (3) est configuré avec un bâti de transport ou pour reprendre sans bâti un ou plusieurs substrats (3).

6. Réacteur (1) selon l'une des revendications 3 à 5, **caractérisé en ce que** le dispositif de reprise de substrat est configuré pour modifier la distance entre le substrat (3) et la surface du côté avant de l'électrode complémentaire (7).

7. Réacteur (1) selon l'une des revendications 3 à 6, **caractérisé en ce qu'**au moins dans une bordure supérieure, le dispositif de reprise de substrat (3) présente au moins un élément supérieur de maintien d'un ou plusieurs substrats (3) et au moins dans une partie inférieure au moins un élément inférieur de maintien pour un ou plusieurs substrats (3).

8. Réacteur (1) selon la revendication 7, **caractérisé en ce que** l'élément supérieur de maintien est configuré comme contre-appui pour les bordures supérieures d'un ou plusieurs substrats (3).

9. Réacteur (1) selon les revendications 7 ou 8, **caractérisé en ce que** l'élément inférieur de maintien est configuré comme élément de pose (115) pour le chant inférieur d'un ou plusieurs substrats (3).

10. Réacteur (1) selon l'une des revendications 7 à 9, **caractérisé en ce que** l'élément supérieur et/ou l'élément inférieur de maintien peuvent être déplacés linéairement et/ou par pivotement par rapport à ladite surface de l'électrode complémentaire (7).

11. Réacteur (1) selon l'une des revendications 7 à 10, **caractérisé en ce que** les éléments de maintien sont configurés de manière à modifier la distance entre le substrat (3) et ladite surface de l'électrode complémentaire (7).

12. Réacteur (1) selon au moins l'une des revendications 7 à 11, **caractérisé en ce que** les éléments de maintien sont configurés de manière à flotter électriquement.

13. Réacteur (1) selon l'une des revendications précédentes, **caractérisé en ce que** l'électrode (5) placée dans une découpe de la structure de maintien (33) est séparée de la paroi de la chambre sous vide par un diélectrique.

14. Réacteur (1) selon l'une des revendications précédentes, **caractérisé en ce que** le réacteur (1) présente un dispositif de manipulation (300) de substrats plats qui présente au moins un module de bras de saisie pour un ou plusieurs substrats, le module (200) de bras de saisie étant configuré de telle sorte que les substrats (3) puissent être déplacés parallèlement à leur surface et soient disposés au moins pendant le chargement et le déchargement d'un espace de traitement (9) avec leur surface à traiter orientée vers le bas sous un angle alpha compris entre 1° et 45° par rapport à la verticale.

15. Procédé de traitement de substrats plats (3), en particulier de revêtement de substrats plats par un matériau de revêtement dans un réacteur qui présente :
une chambre sous vide (11) dans laquelle est disposé un espace de traitement (9), une première électrode (5) et une électrode complémentaire (7) étant prévues pour former un plasma de traitement d'une surface à traiter et formant deux parois opposées de l'espace de traitement (9),
des moyens d'amenée et des moyens d'enlèvement d'un matériau gazeux, en particulier d'un matériau de revêtement et/ou d'un matériau de nettoyage, dans l'espace de traitement (9) ou hors de ce dernier,
le ou les substrats (3) pouvant être repris par le côté avant de l'électrode complémentaire (7),
une ouverture de chargement et de déchargement de la chambre sous vide (11), de préférence dotée d'un dispositif de fermeture (27),
la distance relative entre les électrodes (5; 7) pouvant être ajustée et une première distance relativement grande étant prévue lors du chargement ou du déchargement du ou des substrats (3) dans la chambre de traitement (9) et une deuxième distance, relativement petite, étant prévue lors de l'exécution du traitement du ou des substrats (3),
**caractérisé en ce que**
une structure de maintien (33) est prévue pour l'électrode (5) dans la chambre sous vide (11) et l'électrode (5) est disposée dans une découpe de la structure de maintien (33),
**en ce que** l'électrode complémentaire (7) recouvre la découpe pendant l'exécution du traitement et
un interstice, dimensionné de telle sorte que le plasma formé dans l'espace de traitement (9) soit maintenu ou puisse être maintenu à l'intérieur de l'espace de traitement (9), étant formé entre la bordure de l'électrode complémentaire (7) et la bordure de la découpe.
